**Europäisches Patentamt**

**European Patent Office**

**Office européen des brevets**

(19)

(11) Veröffentlichungsnummer: **0 184 619 B1**

# (12) EUROPÄISCHE PATENTSCHRIFT

(45) Veröffentlichungstag der Patentschrift: **29.01.92**

(21) Anmeldenummer: **85111201.1**

(22) Anmeldetag: **05.09.85**

(51) Int. Cl.⁵: $G01R\ 31/28$

---

(54) **Leiterplatten-Prüfeinrichtung.**

---

(30) Priorität: **14.11.84 DE 3441578**

(43) Veröffentlichungstag der Anmeldung:
**18.06.86 Patentblatt 86/25**

(45) Bekanntmachung des Hinweises auf die
Patenterteilung:
**29.01.92 Patentblatt 92/05**

(84) Benannte Vertragsstaaten:
**AT BE CH DE FR GB IT LI LU NL SE**

(56) Entgegenhaltungen:
**EP-A- 0 026 824**
**EP-A- 0 145 830**
**EP-A- 0 159 907**
**WO-A-84/01831**

(73) Patentinhaber: **RIBA Prüftechnik GmbH**
**Brandhof 4**
**W-7801 Schallstadt(DE)**

(72) Erfinder: **Prokopp, Manfred**
**Kirchäckerstrasse 13**
**W-6980 Wertheim-Waldenhausen(DE)**
Erfinder: **Barth, Hans**
**Erlenweg 7**
**W-7801 Schallstadt(DE)**
Erfinder: **Schmidt, Günter, Dipl.-Ing.**
**Steigäckerstrasse 1**
**W-6980 Wertheim-Waldenhausen(DE)**

(74) Vertreter: **Patentanwälte Dipl.-Ing. Hans**
**Schmitt Dipl.-Ing. Wolfgang Maucher**
**Dreikönigstrasse 13**
**W-7800 Freiburg i.Br.(DE)**

**Beschreibung**

Die Erfindung betrifft eine Leiterplatten-Prüfeinrichtung mit in einem fest vorgegebenen Grundrasterfeld angeordneten Kontakten, die mit einem Rechner verbunden sind und deren Anzahl zumindest der größtmöglichen Anzahl von Prüfpunkten auf einer Leiterplatte entspricht, weiterhin mit einer Andruckvorrichtung für die Leiterplatte sowie mit prüflingsorientierten Verbindungen zwischen den einzelnen Prüfpunkten und Rasterkontakten zum Prüfen von Leiterplatten mit Prüfpunkten, welche zum Teil in einem engeren Raster angeordnet sind als die Grundrasterfeld-Kontakte bzw. die rasterfrei angeordnet sind, wobei das Grundrasterfeld in jedem Rasterpunkt mit einer gefederten Anschlußnadel oder dergleichen bestückt ist, die einerseits Anschlußstellen zum Verbinden mit dem Rechner und andererseits Kontaktspitzen zum Kontaktieren eines Übertragungsumsetzers haben.

Leiterplatten-Prüfeinrichtungen sind in unterschiedlichen Ausführungsformen bereits bekannt. Bei einer Ausführungsform ist vorgesehen, daß in einem Raster angeordnete Prüfpunkte einer Leiterplatte über ebenfalls in diesem Raster angeordnete Kontaktnadeln mit einem Prüfrechner verbunden werden. Um auch außerhalb eines vorgegebenen Rasters angeordnete Leiterplatten-Prüfpunkte erfassen zu können, hat man auch schon Kontaktnadeln schräg angeordnet. Dies ist jedoch nur bei vergleichsweise geringer Prüfpunktdichte und Prüfpunktanzahl durchführbar.

In der Regel werden Zum Adaptieren einer Leiterplatte von den im vollbestückten Grundrasterfeld vorhandenen Kontakten nur ein Teil dieser Kontakte, entsprechend der Anzahl der Leiterplatten-Prüfpunkte, aktiviert. Um jedoch die Verdrahtung des Grundrasterfeldes mit dem Rechner unverändert lassen zu können und um verschiedene Leiterplatten prüfen zu können, ohne daß aufwendige Umstellungen notwendig sind, werden im Grundrasterfeld alle Rasterpunkte belegt. Üblicherweise weist ein Grundrasterfeld im 2,54 mm-Raster (1/10-Zoll-Raster) z. B. 30.000 Kontakte auf, von denen in der Regel bei einem Prüfungsvorgang nur 1.000 bis 10.000 benötigt werden. Die übrigen Kontakte werden für andere Leiterplatten-Konfigurationen bereitgehalten.

Durch die zunehmend größer werdende Packrungsdichte von Bauelementen auf einer Leiterplatte und auch durch die häufig große Anzahl dicht beieinanderliegender Anschlüsse dieser Bauelemente ergeben sich Prüfpunktabstände auf der Leiterplatte, die z. B. durch ein 2,54 mm-Raster (1/10-Zoll-Raster) nicht mehr abgedeckt werden können. Es besteht zwar die Möglichkeit, das Grundraster entsprechend anzupassen und z. B. ein 1,27 mm-Raster (1/20-Zoll-Raster) vorzusehen. Dies ergibt jedoch eine Vervierfachung der Rasterpunkte und bezogen auf 30.000 Kontakte im 2,54 mm-Raster (1/10-Zoll-Raster), entsprechend 120.000 Kontakte im 1,27 mm-Raster (1/20-Zoll-Raster), mit einem Herstellungsaufwand und Materialkosten, die praktisch nicht mehr vertretbar sind. Erhebliche Probleme ergeben sich dann auch bei der Verdrahtung zwischen Grundrasterfeld und Rechner, wobei das Leitungsbündel dann etwa einen meterdicken Querschnitt bei einem Gewicht von einigen Zentnern haben würde.

Wegen dem Abstand der Rasterpunkte von dann z. B. 1,27 mm beim 1,27 mm-Raster (1/20-Zoll-Raster) können auch nur sehr dünne Anschlußdrähte verwendet werden. Dadurch besteht aber wiederum erhöht die Gefahr, daß aus dem Gesamtbündel einzelne Drähte abreißen, wodurch dann Fehlfunktionen auftreten können. Eine Reparatur ist wegen der schlechten Zugänglichkeit der durch den Gesamtkabelstrang verdeckten Anschlußstellen praktisch nicht mehr durchführbar.

Man kennt auch bereits eine Prüfeinrichtung, bei der eine mit dem Grundrasterfeld über Steckverbindungen verbindbare Zwischenplatte vorgesehen ist, die anderseitig für jeden Rasterpunkt flächige Kontaktplättchen aufweist. Durch die flächige Ausbildung dieser Plättchen können auch etwas aus dem Grundraster seitenverschobene Prüfpunkte der Leiterplatte kontaktiert werden. Bei Prüfpunkten, die insbesondere in größerer Anzahl dicht beieinander z. B. im halben Rasterabstand angeordnet sind, ist eine separate Kontaktierung jedoch nicht mehr möglich. Außerdem ergeben sich erhebliche Probleme, wenn diese Zwischenplatte für unterschiedliche Prüflinge ausgewechselt werden soll, da dies zerstörungsfrei praktisch nicht durchführbar ist.

Aus der WO 84/01 831 ist eine Leiterplattenprüfvorrichtung bekannt, bei der zum Adaptieren von Prüfpunkten, die nicht im üblichen Rastermaß angeordnet sind, ein Rasteranpassungsadapter vorgesehen ist. Bei diesem sind schräg angeordnete Rasterprüfstifte des Grundrasterfeldes und die Prüfpunkte eines Prüflings überbrückende Verbindungsstifte vorgesehen. Der Aufbau eines solchen Rasteranpassungsadapters ist jedoch vergleichsweise aufwendig und daher insbesondere auch dessen Herstellung. Außerdem werden hier spezielle Verbindungsstifte mit einem Rundkopf und dazu passende, spezielle Prüfstifte mit einer hohlkegelförmigen Ausnehmung verwendet. Auch dies ist aufwendig.

Mit zunehmender Anzahl von sehr dicht beieinanderliegenden Prüfpunkten ergeben sich bei diesem Rasteranpassungsadapter auch schon bei vergleichsweise geringer Prüfpunktezahl Platzprobleme für die Verbindungsstifte, da diese einerseits selbst und auch verstärkt durch ihre Schrägstellung Platz benötigen und andererseits mit ihren dem jeweiligen Prüfpunkt abgewandten Enden den im größeren Raster und damit größeren Abstand angeordneten Prüfstiften zugeordnet werden müssen. Dabei können sich bei größerer Prüfpunktezahl Verbindungsabstände ergeben, die mit entsprechend schrägstehenden Verbindungsstiften praktisch nicht mehr überbrückt werden können, so daß dieser Rasteranpassungsadapter dann nicht mehr einsetzbar ist.

Schließlich ist durch die nachveröffentlichte EP-A-O 159 907 eine Prüfeinrichtung bekannt, bei der Grundrasterfeld-Kontakte über Kabel und wire-wrap-Verbindungen an Prüfstifte angeschlossen sind. Ein solcher, jeweils für eine bestimmte zu prüfende Leiterplattenausführung passender Adapter oder Übertragungsumsetzer ist umständlich in der Herstellung und bei einer großen Anzahl von dicht beieinanderliegenden Prüfpunkten beim Prüfling nicht mehr einsetzbar.

Aufgabe der vorliegenden Erfindung ist es, eine Leiterplatten-Prüfeinrichtung der eingangs erwähnten Art zu schaffen, mittels der unbestückte Leiterplatten mit hoher Prüfpunktdichte und Prüfpunktanzahl überprüft werden können, ohne daß der Aufwand für die Prüfeinrichtung wesentlich gegenüber bisherigen Prüfeinrichtungen erhöht wird. Insbesonder sollen mit dieser Prüfeinrichtung sowohl Leiterplatten mit im üblichen 2,54 mm-Raster (1/10-Zoll-Raster) angeordneten Prüfpunkten, als auch Leiterplatten mit wesentlich dichteren Prüfungspunktanordnungen z. B. im 1,27 mm-Raster (1/20-Zoll-Raster) geprüft werden können, wobei man aber mit einem unveränderten 2,54 mm-Grundrasterfeld (1/10-Zoll-Grundrasterfeld) auskommt. Dabei soll auch berücksichtigt sein, daß Prüfpunkte in einzelnen Bereichen verdichtet in großer Anzahl vorhanden sind, während Nachbarbereiche keine Prüfpunkte aufweisen, woraus sich erhebliche Druckbelastungs-Unsymmetrien ergeben unter Berücksichtigung eines Adaptierdruckes von insgesamt z. B. 1.000 kp. Auch soll für unterschiedliche Leiterplatten eine problemlose, schnelle Umrüstung der Prüfeinrichtung möglich sein.

Zur Lösung dieser Aufgabe wird vorgeschlagen, daß der Übertragungsumsetzer ein Zwischenteil sowie eine Umsetzerplatte aufweist, die auf einer Seite prüflingsorientierte und auf der anderen Seite rasterorientierte, jeweils miteinander verbundene Anschlüsse trägt, daß die Umsetzerplatte zwischen einander zugeordneten Anschlüssen Verbindungsleitungen aufweist, die über durchkontaktierte senkrecht zur Umsetzerplatte angeordneten Bohrungen miteinander verbunden sind, daß das Zwischenteil zwischen der Umsetzerplatte und der zu prüfender Leiterplatte angeordnet ist und zumindest bei Druckbeaufschlagung elektrisch leitende Verbindungen zum Verbinden der Prüfpunkte sowie der diesen zugeordneten Anschlüsse auf der Umsetzerplatte aufweist, und daß das Zwischenteil als flächig durchgehendes Druckübertragungsteil ausgebildet ist, dessen Oberflächen gegeneinander abgestützt sind.

Bei dieser Ausbildung kann eine schnelle Umrüstung auf verschiedene Prüflinge erfolgen, da der Übertragungsumsetzer, der jeweils entsprechend der Prüfpunktanordnung der zu prüfenden Leiterplatte aufgebaut ist, leicht ausgewechselt werden kann. Durch den Übertragungsumsetzer können bei gleichbleibendem Grundrasterfeld Leiterplatten mit unterschiedlichster Prüfpunktanordnung, auch solche mit 1,27 mm-Raster (1/20-Zoll-Raster) bei einem 2,54 mm-Raster (1/10-Zoll-Raster) des Grundrasterfeldes, adaptiert werden, woraus sich erhebliche Vereinfachungen bei der Konstruktion und Montage ergeben. Die Ausbildung des Zwischenteiles als Druckübertragungsteil ergibt eine praktisch vollflächige Übertragung des Arbeitsdruckes zwischen dem Grundraster-Nadelfeld und einer Andruckplate, so daß insbesondere auch Deformierungen der Umsetzerplatte mit daraus resultierenden Kontaktierungenauigkeiten vermieden werden.

Die Ausbildung der Umsetzerplatte als Leiterplatte ermöglicht eine besonders einfache Herstellung, die gleich bei der Herstellung der jeweiligen Prüflinge mit vorgenommen werden kann.

Eine Ausgestaltung der Erfindung, für die selbständiger Schutz beansprucht wird, sieht vor, daß das Zwischenteil einen plattenförmigen Grundkörper aus isolierendem, elastischem Material aufweist, in dem etwa senkrecht zur Plattenebene von einer Plattenseite zur anderen verlaufende, gegeneinander isolierte Leitkörper eingebettet sind. Ein solches Zwischenteil kann eine Vielzahl von Leitkörpern aufweisen, die in einer bevorzugten Ausführungsform einen Seitenabstand von etwa 1/10 mm bis zu 1 mm haben können, so daß es insbesondere dann vorteilhaft einsetzbar ist, wenn eine große Anzahl von Prüfpunkten vorhanden ist. Dabei ist vorteilhaft, daß das Zwischenteil bei sehr dichter Anordnung von Leitkörpern ohne exakte Positionierung zwischen Prüfling und Umsetzerplatte eingelegt werden kann. Weiterhin ist von besonderem Vorteil, daß dieses Zwischenteil unverändert für verschiedene Leiterplatten einsetzbar ist. Durch den elastischen Grundkörper kann dieser beim Andrücken der Leiterplatte etwas elastisch nachgeben, so daß eine gute Kontaktierung zwischen Leiterplatte und Zwischenteil einerseits und zwischen Zwischenteil und Umsetzerplatte andererseits möglich ist.

Die Leitkörper in dem Zwischenteil-Grundkörper können nach einer Ausführungsform der Erfindung durch jeweils ein biegeelastisches Drahtstückchen gebildet sein, deren seitliche Ausdehnungen vorzugsweise Durchmesser, z. B. etwa dem halben Seitenabstand nebeneinander benachbarter Leitkörper entspricht. Diese Drahtstückchen bilden dann die Verbindung von einer Oberfläche des Zwischenteiles zu dessen anderer Oberfläche. Einerseits durch die selbst biegeelastischen Drahtstückchen und auch durch die elastische Ausbildung des sie umgebenden Grundkörpers des Zwischenteiles ist ein gewisser Federweg vorhanden, durch den eine sichere Kontaktierung an den Enden der Drahtstückchen gegeben ist.

Eine andere Ausführungsform eines Zwischenteiles sieht vor, daß die Leitkörper jeweils durch etwa reihenartige, z. B. perlenkettenartig quer zu den Oberflächen des Zwischenteiles übereinander angeordnete Einzelkörper, vorzugsweise Kugeln gebildet sind, wobei zwischen wenigstens zwei Einzelkörpern jeder Kette in Ausgangsposition ein Abstand besteht und wobei der Zwischenteil-Grundkörper mindestens um die Summe der Abstände einer Kette elastisch zusammendrückbar ist. Bei dieser Ausführungsform eines Zwischenteiles ist durch den Abstand der Leitkörper voneinander in Ausgangslage ein vergleichsweise großer elastischer Federweg bei gleichzeitig geringem, notwendigem Kontaktdruck möglich. Die einzelnen, in Ausgangslage voneinander getrennten Leitkörper kommen bei Druckbeaufschlagung in Kontakt miteinander und bilden dann eine Leitverbindung jeweils von einer Plattenseite zur anderen. Auch hierbei ist der erhebliche Vorteil vorhanden, daß bei einer z. B. auch rasterförmigen Anordnung der Leitkörper mit einem Seitenabstand, der etwa dem kleinsten Prüfpunktabstand entspricht oder gegebenenfalls auch kleiner ist, das Zwischenteil unabhängig vom Prüfling bzw. dessen Prüfpunkt-Anordnung, eingesetzt werden kann.

Gegebenenfalls kann das Zwischenteil auch als Nadelträgerblock mit prüflingsorientierten Bohrungen zur Aufnahme und Führung von Kontaktnadeln ausgebildet sein. Ein solches Zwischenteil ist insbesondere dort einsetzbar, wo die Prüfpunkte nicht in einer Ebene liegen, sondern vergleichsweise große Höhenunterschiede aufweisen.

Zusätzliche Ausgestaltungen der Erfindung sind in den weiteren Unteransprüchen aufgeführt.

Nachstehend ist die Erfindung anhand eines Ausführungsbeispieles in den Zeichnungen noch näher erläutert.

Es zeigt zum Teil stärker schematisiert:

Fig. 1 eine perspektivische Teil-Vorderseitenansicht einer Leiterplatten-Prüfeinrichtung,

Fig. 2 eine Querschnitts-Detailansicht im Bereich einer Umsetzerplatte,

Fig. 3 eine Oberseitenansicht eines Ausschnittes einer Umsetzerplatte,

Fig. 4 einen Ausschnitt eines Grundrasterfeldes,

Fig. 5 eine perspektivische Darstellung einer Prüfeinrichtung etwa vergleichbar mit Fig. 1, hier jedoch mit einem abgewandelt ausgebildeten Übertragungsumsetzer,

Fig. 6 eine Querschnittsdarstellung eines Abschnittes eines Zwischenteiles und

Fig. 7 eine etwa Fig. 6 entsprechende Darstellung, hier jedoch mit anderen Leitkörpern.

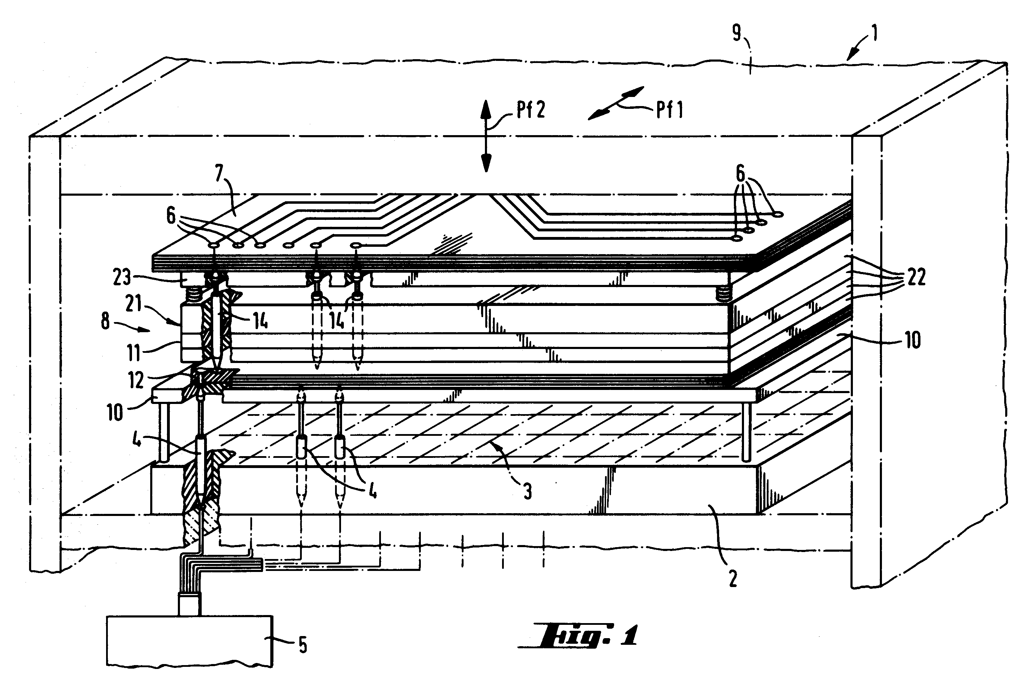

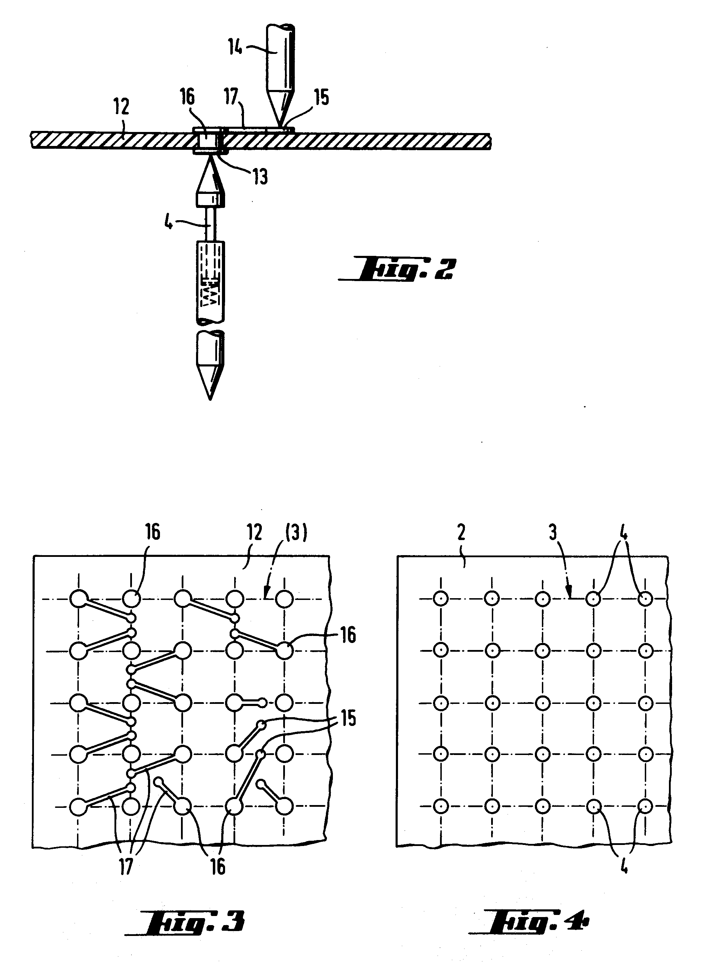

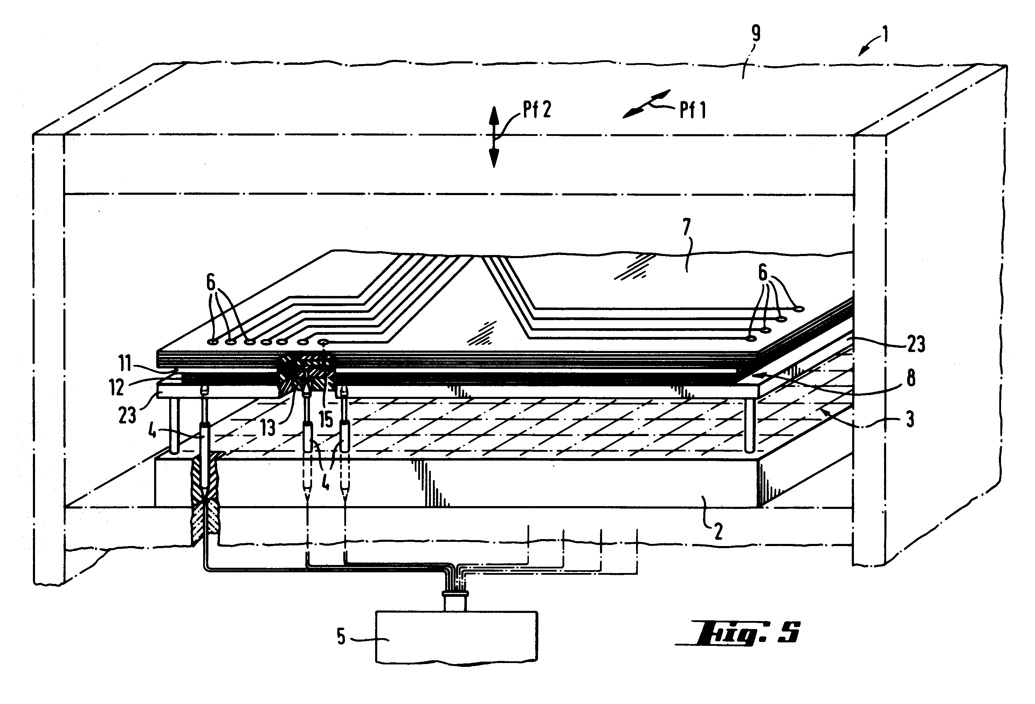

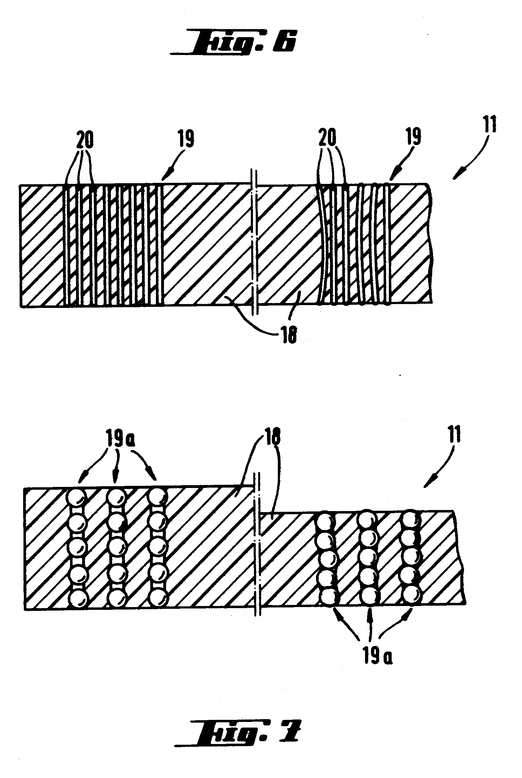

Eine in den Figuren 1 und 5 gezeigte, im ganzen mit 1 bezeichnete Leiterplatten-Prüfeinrichtung weist eine Grundplatte 2 mit in einem fest vorgegebenen Grundrasterfeld 3 angeordneten Kontakten 4 auf. In jedem Rasterpunkt, der sich im Schnittpunkt von strichpunktiert angedeuteten Rasterlinien befindet, sind solche Kontakte 4 angeordnet, von denen zur Vereinfachung in den Zeichnungen nur jeweils drei gezeigt sind. Diese Kontakte 4 sind über elektrische Leitungen mit einem Rechner 5 verbunden. Die Anzahl von Kontakten 4 einer voll bestückten Grundplatte 2 beträgt in der Regel ein Vielfaches von der größtmöglichen Anzahl von Prüfpunkten 6 einer zu prüfenden Leiterplatte 7. Ein Grundrasterfeld 3 kann bei einer 2,54 mm-Rasterung (1/10-Zoll-Rasterung) beispielsweise 30.000 Kontakte 4 aufweisen, während ein Prüfling in der Regel 1.000 bis 10.000 Prüfpunkte 6 aufweist. Die Kontakte 4 des Grundrasterfeldes 3 sind im Ausführungsbeispiel als gefederte Kontaktnadeln ausgebildet. Fig. 4 zeigt in Aufsicht einen Teil eines Grundrasterfeldes 3.

Oberhalb des Grundrasterfeldes 3 befindet sich ein Übertratungsumsetzer 8, der zwischen den Prüfpunkten 6 der Leiterplatte und den Kontakten 4 des Grundrasterfeldes einzelne elektrische Verbindungen herstellt. Dabei können die Prüfpunkte 6 rasterfrei oder in größerem oder kleinerem Rasterabstand angeordnet sein als die Kontakte 4 des jeweils unverändert bleibenden Grundrasterfeldes 3. Weiterhin gehört zu der Leiterplatten-Prüfeinrichtung 1 eine Andruckvorrichtung 9, die nur strichpunktiert angedeutet ist. Nach dem Auflegen der zu prüfenden Leiterplatte 7 auf den Übertragungsumsetzer 8, wird die Andruckvorrichtung 9 etwa schubladenartig über diese Anordnung gefahren (Pf 1) und drückt dann zum Adaptieren die Leiterplatte 7 durch eine Hubbewegung gemäß dem Pfeil Pf 2 nach unten, wobei die Kontaktverbindung zwischen den Prüfpunkten 6 und den Kontakten 4 bzw. dem Rechner 5 hergestellt werden.

Mit Hilfe der erfindungsgemäßen Leiterplatten-Prüfeinrichtung können Leiterplatten mit in gegenüber dem Grundrasterfeld 3 in einem anderen Raster oder rasterfrei angeordnete Prüfpunkte 6 der Leiterplatte 7 erfaßt werden. Insbesondere weist das Grundrasterfeld 3 bei einem 2,54 mm-Raster (1/10-Zoll-Raster) entsprechende Rasterabstände auf, wobei der Verdrahtungs- und Materialaufwand noch in einem vergleichsweise gut realisierbarem Rahmen liegt.

Das Grundrasterfeld 3 weist noch eine mit Abstand zu der Grundplatte 2 angeordnete Führungsplatte 10 auf, die Bohrungen für die Kontaktnadeln 4 hat, wobei diese ohne aufgelegten Übertragungsumsetzer 8 etwas über die Oberseite dieser Führungsplatte 10 vorstehen.

Durch die Ausbildung des Grundrasterfeldes 3 mit Kontaktnadeln 4 od. dgl. besteht in vorteilhafter Weise die Möglichkeit, einen prüflingsorientierten - d. h. entsprechend dem jeweiligen Prüfling ausgebildeten - Übertragungsumsetzer 8 einfach auswechseln zu können. Zum lagerichtigen Aufsetzen des Übertragungsumsetzers 8 auf das Grundrasterfeld 3 bzw. dessen Führungsplatte 10 sind entsprechende, hier nicht dargestellte Führungsmittel, z. B. Führungsstifte und Führungsbohrungen vorgesehen.

Der Übertragungsumsetzer 8 besteht im wesentlichen aus einem Zwischenteil 11 sowie einer Umsetzerplatte 12. Die Umsetzerplatte 12 weist auf der der Leiterplatte 7 zugewandten Seite prüflingsorientierte und auf der anderen Seite rasterorientierte, jeweils miteinander verbundene Anschlüsse auf. Fig. 2 zeigt in einer Detail-Schnittdarstellung eine solche Verbindungsstelle, wobei eine Kontaktnadel 4 einen entsprechend rasterorientierten Anschluß 13 und auf der anderen Seite eine Kontaktnadel 14 einen prüflingsorientierten Anschluß 15 kontaktieren. Über eine durchkontaktierte Bohrung 16 sowie eine Leiterbahn 17 sind die beiden Anschlüsse 13 und 15 miteinander verbunden. Bei komplizierten Prüflingen mit einer großen Anzahl von Prüfpunkten 6 ist die Umsetzerplatte 12 zweckmäßigerweise als Mehrschichtplatte (multilayer) ausgebildet. Durch die Umsetzerplatte 12 besteht auch die Möglichkeit, Leiterplatten 7 zu überprüfen, deren Prüfpunkte 6 in einem kleineren Raster als dem Raster des Grundrasterfeldes 3 angeordnet sind. Beispielsweise kann somit eine Leiterplatte mit im 1,27 mm-Raster (1/20-Zoll-Raster) angeordneten Prüfpunkten überprüft werden, obwohl unverändert ein 2,54 mm - (1/10 Zoll) Rasterfeld als Grundrasterfeld 3 vorhanden ist (vgl. auch Fig. 3).

Das Zwischenteil 11 ist als flächig durchgehendes, im wesentlichen massives Druckübertragungsteil ausgebildet. Durch das Zwischenteil werden zumindest bei Druckbeaufschlagung elektrisch leitende Verbindungen zwischen Prüfpunkten 6 einer Leiterplatte 7 und den Anschlüssen 15 der Umsetzerplatte 12 hergestellt. Nach einer bevorzugten Ausführungsform der Erfindung weist das Zwischenteil einen plattenförmigen Grundkörper 18 (vgl. Fig. 6 und 7) aus isolierendem, elastischem Material auf, in dem etwa senkrecht zur Plattenebene von einer Plattenseite zur anderen verlaufende, gegeneinander isolierte Leitkörper 19, 19 a eingebettet sind. Auch hierbei bildet das Zwischenteil einen Druckübertragungskörper, der zwar etwas nachgiebig ist, insgesamt jedoch eine durchgehende Abstützung zwischen Prüfling und Umsetzerplatte 12 bildet. Die im Grundkörper eingebetteten Leitkörper 19 bzw. 19 a haben zweckmäßigerweise einen Seitenabstand, der gleich oder vorzugsweise kleiner ist als der kleinste Abstand von Prüfpunkten auf einer zu überprüfenden Leiterplatte 7. Bei sehr enger Anordnung dieser Leitkörper hat man den erheblichen Vorteil, daß das Zwischenteil 11 in seiner Seitenlage relativ zu dem Prüfling und der Umsetzerplatte 12 nicht exakt positioniert werden muß.

Gemäß der Ausführungsform nach Fig. 6 sind die Leitkörper 19 durch jeweils biegeelastische Drahtstückchen 20 gebildet, die mit ihren Enden vorzugsweise etwa an den Oberflächen des Grundkörpers 8 abschließen. Bei Druckbeaufschlagung des Zwischenteiles während des Adaptierens wird der Grundkörper 18 etwas zusammengedrückt, wobei die Drahtstückchen 20 elastisch verformt werden, wie dies in Fig. 6 rechtsseitig angedeutet ist. Durch die Eigenelastizität der Drahtstückchen 20 und auch unterstützt durch das elastische Material des Grundkörpers 18, federn die Drahtstückchen 20 nach Entlastung des Zwischenteiles 11 wieder in ihre gestreckte Lage, wie linksseitig dargestellt, aus. Erwähnt sei noch, daß die Drahtstückchen 20 eventuell eine geringfügige Vorbiegung aufweisen können, so daß der Kontaktdruck dadurch beeinflußbar ist. Gegebenenfalls ist auch eine in einer Richtung vororientierte Ausknickung der Drahtstückchen 20 vorgesehen.

Eine andere Ausführungsform eines Zwischenteiles 11 mit darin eingebetteten Leitkörpern 19 a ist abschnittweise in Fig. 7 gezeigt. Hierbei sind die Leitkörper 19 a jeweils durch etwa reihenartig, z. B. perlenkettenartig quer zu den Oberflächen des Zwischenteiles 11 übereinander angeordnete Einzelkörper, vorzugsweise Kugeln gebildet. Diese weisen in Ausgangsposition (linksseitig) einen Abstand voneinander auf, so daß das Zwischenteil 11 insgesamt einen Isolator bildet. Bei Druckbeaufschlagung gelangen die einzelnen Leitkörperteile jeder Kette in Kontakt miteinander und bilden dann eine Leitverbindung von einer Plattenseite zur anderen an den jeweiligen Oberflächenkontaktstellen, die jedoch zu benachbarten isoliert sind. Der Grundkörper 18 dieses Zwischenteiles 11 ist etwa um die Summe der Abstände einer Leitkörper-Teilekette elastisch zusammendrückbar. Bevorzugt besteht der Grundkörper 18 des Zwischenteiles 11 aus Silikonkautschuk oder ähnlichem isolierenden, elastischem Material. Der Grundkörper 18 und somit das Zwischenteil 11 kann bei dieser Ausführungsform folienartig mit einer Dicke von beispielsweise etwa 0,5 mm bis zu einer Dicke von einigen Millimetern ausgebildet sein.

Fig. 1 zeigt noch eine abgewandelte Ausführungsform einer Leiterplatten-Prüfeinrichtung 1, bei der das Zwischenteil 11 als Nadelträgerblock 21 ausgebildet ist. Dieser Nadelträgerblock 21 weist prüflingsorientierte Bohrungen zur Aufnahme und Führung von Kontaktnadeln 14 auf. Diese Ausbildung eines Zwischenteiles 11 ist insbesondere dann vorteilhaft, wenn die Prüfpunkte 6 einer Leiterplatte 7 vergleichsweise große Höhenabweichungen haben. Diese Höhendifferenzen können jedoch gut durch die in sich federnden Kontaktnadeln 14 ausgeglichen werden. Auch der Nadelträgerblock ist als Druckübertragungsteil ausgebildet und besteht dazu zur Abstützung der Oberflächen mehrschichtig aus aufeinanderliegenden Einzelplatten 22. Diese mehrschichtige Ausbildung ist herstellungstechnisch einfach mit den entsprechenden Bohrungen zu versehen.

Die Ausbildung des Zwischenteiles 11 als Druckübertragungsteil ergibt eine im wesentlichen vollflächige Druckübertragung zwischen Grundrasterfeld 3 und Andruckvorrichtung 9. Insbesondere wird durch das so ausgebildete Zwischenteil 11 vermieden, daß insbesondere die Umsetzerplatte 12 deformiert wird. Beim Adaptieren erfolgt nämlich im Bereich von Prüfpunkten 6 eine durchgehende Druckübertragung, während in den Nachbarbereichen die Kontaktnadeln 4 des Grundrasterfeldes 3 gegen die Umsetzerplatte 12 drücken. Durch die Ausbildung des Zwischenteiles 11 als Druckübertragungsteil wird jedoch auch diese Andruckkraft über die Leiterplatte 7 an die Andruckvorrichtung 9 übertragen. Durch die Ausbildung des Zwischenteiles als im wesentlichen massives Druckübertragungsteil kann sowohl dieses als auch die Umsetzerplatte 12 aus vergleichsweise dünnem Material bestehen.

In Fig. 1 ist noch erkennbar, daß der Nadelträgerblock 21 auf der dem Prüfling zugewandten Seite eine mit Abstand angeordnete, gefederte Stützplatte 23 zur flächigen Unterstützung des Prüflings 7 aufweist. Die Stützplatte weist Durchtrittsbohrungen für die Kontaktnadeln 14 auf. In Ausgangslage befindet sich die Oberseite dieser Stützplatte sowie die Enden der Kontaktnadeln 14 etwa in einer Ebene. Beim Adaptiervorgang, wo die Andruckvorrichtung 9 abgesenkt wird, wird dann auch die Stützplatte 23 nach unten gedrückt, bis sie auf den Einzelplatten 22 des Nadelträgerblokkes 21 aufliegt.

**Patentansprüche**

1. Leiterplatten-Prüfeinrichtung mit in einem fest vorgegebenen Grundrasterfeld (3) angeordneten Kontakten (4), die mit einem Rechner (5) verbunden sind und deren Anzahl zumindest der größtmöglichen Anzahl von Prüfpunkten (6) auf einer Leiterplatte (7) entspricht, weiterhin mit einer Andruckvorrichtung (9) für die Leiterplatte (7) sowie mit prüflingsorientierten Verbindungen (14) zwischen den einzelnen Prüfpunkten (6) und Rasterkontakten zum Prüfen von Leiterplatten (7) mit Prüfpunkten (6), welche zum Teil in einem engeren Raster angeordnet sind als die Grundrasterfeld-Kontakte (4) bzw. rasterfrei angeordnet sind, wobei das Grundrasterfeld (3) in jedem Rasterpunkt mit einer gefederten Anschlußnadel (4) oder dergleichen bestückt ist, die einerseits Anschlußstellen zum Verbinden mit dem Rechner (5) und andererseits Kontaktspitzen zum Kontaktieren eines Übertragungsumsetzer (8) haben, **dadurch gekennzeichnet,** daß der Übertragungsumsetzer (8) ein Zwischenteil (11) sowie eine Umsetzerplatte (12) aufweist, die auf einer Seite prüflingsorientierte und auf der anderen Seite rasterorientierte, jeweils miteinander verbundene Anschlüsse (15,13) trägt, daß die Umsetzerplatte (12) zwischen einander zugeordneten Anschlüssen (13, 15) Verbindungsleitungen (17) aufweist, die über durchkontaktierte senkrecht zur Umsetzerplatte angeordneten Bohrungen (16) miteinander verbunden sind, daß das Zwischenteil (11) zwischen der Umsetzerplatte (12) und der zu prüfenden Leiterplatte (7) angeordnet ist und zumindest bei Druckbeaufschlagung elektrisch leitende Verbindungen (14) zum Verbinden der Prüfpunkte (6) sowie der diesen zugeordneten Anschlüssen (15) auf der Umsetzerplatte (12) aufweist, und daß das Zwischenteil (11) als flächig durchgehendes Druckübertragungsteil ausgebildet ist, dessen Oberflächen gegeneinander abgestützt sind.

2. Prüfeinrichtung nach Anspruch 1, dadurch gekennzeichnet, daß das Zwischenteil (11) durch ein im wesentlichen massives Teil gebildet ist.

3. Prüfeinrichtung nach Anspruch 1 oder 2, dadurch gekennzeichnet, daß zur kreuzungsfreien Anordnung der Verbindungsleitungen (17) die Umsetzerplatte (12) gegebenenfalls mehrlagig ausgebildet ist.

4. Prüfeinrichtung nach einem der Ansprüche 1 bis 3, dadurch gekennzeichnet, daß die Nadeln (4) des Grundrasterfeldes (3) insbesondere für Leiterplattengrößen von bis zu etwa 50 x 50 cm in einem 2,54 mm-Raster (1/10-Zoll-Raster) mit etwa 30.000 Kontakten, gegebenenfalls in einem Raster mit größerem Rasterabstand angeordnet sind.

**5.** Prüfeinrichtung nach Anspruch 1 bis 4, dadurch gekennzeichnet, daß das Zwischenteil (11) einen plattenförmigen Grundkörper (18) aus isolierendem, elastischem Material aufweist, in dem etwa senkrecht zur Plattenebene von einer Plattenseite zur anderen verlaufende, gegeneinander isolierte Leitkörper (19, 19 a) eingebettet sind.

**6.** Prüfeinrichtung nach Anspruch 5, dadurch gekennzeichnet, daß der Seitenabstand der Leitkörper (19, 19a) gleich oder vorzugsweise kleiner ist als der kleinste Abstand von Prüfpunkten auf einer Leiterplatte und etwa 0,1 bis 1 mm, vorzugsweise 0,3 mm beträgt.

**7.** Prüfeinrichtung nach Anspruch 5 oder 6, dadurch gekennzeichnet, daß die Leitkörper (19) durch jeweils ein biegeelastisches Drahtstückchen (20) gebildet sind, deren seitliche Ausdehnung, vorzugsweise Durchmesser z. B. etwa dem halben Seitenabstand nebeneinander benachbarter Leitkörper entspricht oder gegebenenfalls etwas größer ist.

**8.** Prüfeinrichtung nach Anspruch 5 oder 6, dadurch gekennzeichnet, daß die Leitkörper (19 a) jeweils durch etwa reihenartig, z. B. perlenkettenartig quer zu den Oberflächen des Zwischenteiles (11) übereinander angeordnete Einzelkörper, vorzugsweise Kugeln gebildet sind, wobei zwischen wenigstens zwei Einzelkörpern jeder Kette in Ausgangslage ein Abstand besteht und wobei der Zwischenteil-Grundkörper mindestens um die Summe der Abstände einer Kette elastisch zusammendrückbar ist.

**9.** Prüfeinrichtung nach einem der Ansprüche 5 bis 8, dadurch gekennzeichnet, daß der Grundkörper (18) des Zwischenteiles (11) aus Silikonkautschuk od. dgl. elastischem Isoliermaterial besteht.

**10.** Prüfeinrichtung nach einem der Ansprüche 1 bis 4, dadurch gekennzeichnet, daß das Zwischenteil (11) als Nadelträgerblock (21) ausgebildet ist mit prüflingsorientierten Bohrungen zur Aufnahme und Führung von Kontaktnadeln (14).

**11.** Prüfeinrichtung nach Anspruch 10, dadurch gekennzeichnet, daß der Nadelträgerblock (21) zur Abstützung der Oberflächen mehrschichtig aus aufeinanderliegenden Einzelplatten (22) besteht.

**12.** Prüfeinrichtung nach Anspruch 10 oder 11, dadurch gekennzeichnet, daß der Nadelträgerblock (21) auf der dem Prüfling zugewandten Seite eine mit Abstand angeordnete, gefederte Stützplatte (23) zur Unterstützung des Prüflings (7) aufweist, die Durchtrittsbohrungen für die Kontaktnadeln (14) hat.

## Claims

**1.** A printed circuit testing device including contacts (4) arranged in a predetermined basic grid (3), said contacts being connected to a computer (5) and corresponding in number to at least the greatest possible number of test points (6) on a printed circuit board (7), further including a device (9) for pressing on the printed circuit board (7), as well as test specimen-oriented connections (14) between the individual test points (6) and grid contacts to test printed circuit boards (7) having test points (6) some arranged in a closer grid than the basic grid contacts (4) or arranged grid-free, the basic grid (3) having inserted in each grid point a sprung contact needle (4) or the like having on one side connecting points for connecting to the computer (5) and on the other side contact tips for contacting a transmission converter (8), characterized in that the transmission converter (8) has an intermediate part (11) as well as a converter board (12) having on one side test specimen-oriented and on the other side grid-oriented terminals (15, 13) which are in each case interconnected, that the converter board (12) has between terminals (13, 15) assigned to one another connecting lines (17) interconnected by way of plated-through bores (16) arranged perpendicular to the converter board, that the intermediate part (11) is arranged between the converter board (12) and the printed circuit board (7) to be tested and has at least upon pressurization electrically conductive connections (14) for connecting the test points (6) as well as the terminals (15) assigned thereto on the converter board (12), and that the intermediate part (11) takes the form of a pressure transmission member planar throughout, the surfaces thereof being supported against one another.

**2.** A testing device as claimed in claim 1, characterized in that the intermediate part (11) is composed by a substantially solid member.

**3.** A testing device as claimed in claim 1 or claim 2, characterized in that for non-crossing arrangement of the connecting lines (17) the converter board (12) may be of multilayered configuration.

4. A testing device as claimed in any one of claims 1 to 3, characterized in that the needles (4) of the basic grid (3), particularly for printed circuit board sizes of up to about 50 x 50 cm, are arranged in a 2.54 mm grid (1/10 inch grid) with approx. 30,000 contacts, possibly in a grid with larger grid spacing.

5. A testing device as claimed in claims 1 to 4, characterized in that the intermediate part (11) has a platelike corpus (18) of insulating, elastic material embedding conductive bodies (19, 19a) which are insulated from one another and run approximately perpendicular to the plane of the plate from one side thereof to the other.

6. A testing device as claimed in claim 5, characterized in that the lateral distance of the conductive bodies (19, 19a) is equal to or preferably smaller than the smallest distance of test points on a printed circuit board and is about 0.1 to 1 mm, preferably 0.3 mm.

7. A testing device as claimed in claim 5 or claim 6, characterized in that the conductive bodies (19) are formed in each case by a small piece of wire (20) of flexural elasticity, the lateral expanse of which, preferably diameter, corresponds to e.g. about half the lateral distance of adjacent conductive bodies or possibly is somewhat larger.

8. A testing device as claimed in claim 5 or claim 6, characterized in that the conductive bodies (19a) are composed in each case by discrete bodies, preferably balls, which are arranged one above the other approximately in line, e.g. in the manner of a strand of pearls, transversely to the surfaces of the intermediate part (11), in the starting position there being a space between at least two discrete bodies of each chain and the corpus of the intermediate part being elastically compressible at least to the amount of the sum of the spaces of a chain.

9. A testing device as claimed in any one of claims 5 to 8, characterized in that the corpus (18) of the intermediate body (11) consists of silicone rubber or similar elastic insulating material.

10. A testing device as claimed in any one of claims 1 to 4, characterized in that the intermediate part (11) takes the form of a needle carrier block (21) with test specimen-oriented bores to receive and guide contact needles (14).

11. A testing device as claimed in claim 10, characterized in that the needle carrier block (21) consists multilayered of individual plates (22) lying on top of one another to support the surfaces.

12. A testing device as claimed in claim 10 or claim 11, characterized in that on the side facing the test specimen, the needle carrier block (21) has a spaced, sprung supporting plate (23) which serves for support of the test specimen (7) and has through-bores for the contact needles (14).

**Revendications**

1. Dispositif de test pour plaquettes à circuits imprimés, avec des contacts (4) qui sont disposés dans un champ quadrillé de base (3) prédéterminé d'une manière fixe, qui sont reliés à un ordinateur (5) et dont le nombre correspond au moins au nombre maximal de points de contrôle (6) sur une plaquette imprimée (7), avec en outre un dispositif (9) pour exercer une pression d'application sur la plaquette imprimée (7), ainsi qu'avec des raccordements (14) orientés vers les plaquettes à tester, entre les différents points de contacts (6) et des contacts de trame pour tester des plaquettes imprimées (7) présentant des points de contrôle (6) qui sont en partie disposés dans une trame plus étroite que les contacts (4) du champ quadrillé de base, ou qui sont disposés sans trame, le champ quadrillé de base (3) étant équipé en chaque point de la trame d'une aiguille de connexion élastique (4) ou similaire, ces aiguilles possédant d'un côté des points de connexion pour les relier à l'ordinateur (5) et de l'autre côté des pointes de contacts pour la mise en contact d'un convertisseur de transmission (8), **caractérisé** en ce que le convertisseur de transmission (8) présente une pièce intermédiaire (11) ainsi qu'une plaque de conversion (12) qui porte d'un côté des connexions orientées vers les plaquettes à tester et de l'autre des connexions orientées vers la trame, ces connexions (15,13) étant chaque fois mutuellement reliées, en ce que la plaque de conversion (12) présente, entre des connexions (13,15) mutuellement associées, des lignes de raccordement (17) qui sont reliées entre elles par l'intermédiaire de perçages de contact traversant (16) qui sont disposés perpendiculairement à la plaque de conversion, en ce que la pièce intermédiaire (11) est disposée entre la plaque de conversion (12) et la plaquette imprimée à tester (7), et présente des raccordements (14) qui sont électriquement conducteurs au moins lorsqu'elle est sollicitée en pression et qui sont destinées à relier les points de contrôle (6) ainsi que les connexions (15) qui leur sont associées sur la plaque de conversion (12), et en ce que la pièce intermédiaire est réalisée sous la forme d'une pièce de transmission de pression plate et continue, dont les surfaces sont mutuellement soutenues.

2. Dispositif de test selon la revendication 1, caractérisé en ce que la pièce intermédiaire (11) est constituée par une pièce essentiellement massive.

3. Dispositif de test selon la revendication 1 ou 2, caractérisé en ce que la plaque de conversion (12) est éventuellement réalisée en plusieurs couches, afin que les lignes de jonction (17) soient disposées sans croisements.

4. Dispositif de test selon l'une des revendications 1 à 3, caractérisé en ce que les aiguilles (4) du champ quadrillé de base (3) destiné notamment pour des tailles de plaquettes imprimées allant jusqu'à environ 50 x 50 cm, sont disposées dans une trame présentant un pas de 2,54 mm (pas de trame de 1/10 de pouce) et environ 30000 contacts, éventuellement dans une trame de plus grand pas.

5. Dispositif de test selon l'une des revendications 1 à 4, caractérisé en ce que la pièce intermédiaire (11) présente un corps de base en forme de plaque (18) en matériau élastique isolant, dans lequel sont encastrés des corps conducteurs (19,19a) isolés les uns par rapport aux autres et s'étendant approximativement perpendiculairement au plan de la plaque d'un côté de la plaque à l'autre.

6. Dispositif de test selon la revendication 5, caractérisé en ce que l'écartement latéral des corps conducteurs (19,19a) est égal ou de préférence inférieur à l'écartement minimal des points de contrôle sur une plaquette imprimée, et est approximativement compris entre 0,1 et 1 mm, et de préférence égal à 0,3 mm.

7. Dispositif de test selon la revendication 5 ou 6, caractérisé en ce que les corps conducteurs (19) sont constitués chacun par un morceau de fil (20) élastique en flexion, dont l'étendue latérale, de préférence le diamètre, est égale ou éventuellement légèrement supérieure à, par exemple, approximativement la moitié de l'écartement latéral de corps conducteurs voisins juxtaposés.

8. Dispositif de test selon la revendication 5 ou 6, caractérisé en ce que les corps conducteurs (19a) sont chacun constitués de corps individuels, de préférence des billes, qui sont superposés approximativement en rangées, par exemple à la manière de colliers de perles, perpendiculairement aux surfaces de la pièce intermédiaire (11), un écart étant présent à l'état initial entre au moins deux corps individuels de chaque collier ou chaîne, et le corps de base de la pièce intermédiaire pouvant être comprimé élastiquement au moins de la somme des écarts d'une chaîne.

9. Dispositif de test selon l'une des revendications 5 à 8, caractérisé en ce que le corps de base (18) de la pièce intermédiaire (11) est réalisé en caoutchouc au silicone, ou autre matériau isolant élastique analogue.

10. Dispositif de test selon l'une des revendications 1 à 4, caractérisé en ce que la pièce intermédiaire (11) est réalisée sous forme de bloc porte-aiguilles (21), avec des perçages orientés vers la plaquette à tester et destinés à recevoir et guider des aiguilles de contact (14).

11. Dispositif de test selon la revendication 10, caractérisé en ce que le bloc porte-aiguilles (21) est constitué, en vue du soutien des surfaces, de plusieurs couches constituées de plaques individuelles superposées (22).

12. Dispositif de test selon la revendication 10 ou 11, caractérisé en ce que le bloc porte-aiguilles (21) présente, du côté tourné vers la plaquette à tester, une plaque de soutien (23), disposée à distance et élastiquement suspendue, qui est destinée à soutenir la plaquette à tester (7) et possède des perçages de passage pour les aiguilles de contact (14).

Fig. 1

Fig. 2

Fig. 3

Fig. 4

Fig. 5

Fig. 6

Fig. 7

13